(19)

Europäisches
Patentamt
European
Patent Office
Office européen
des brevets

(11) **EP 4 442 788 A1**

(12) **EUROPEAN PATENT APPLICATION**

(43) Date of publication:
   **09.10.2024   Bulletin 2024/41**

(21) Application number: **24153350.4**

(22) Date of filing: **23.01.2024**

(51) International Patent Classification (IPC):
   *C09K 5/10* (2006.01)      *H01M 10/6567* (2014.01)

(52) Cooperative Patent Classification (CPC):
   **C09K 5/10; H01M 10/6567**

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **GE KH MA MD TN**

(30) Priority:   **04.04.2023   KR 20230044338**

(71) Applicants:
   • **SK Innovation Co., Ltd.**
      **Seoul 03188 (KR)**
   • **SK Enmove Co., Ltd.**
      **Seoul 03188 (KR)**

(72) Inventors:
   • **JUNG, Kang Min**
      **34124 Daejeon (KR)**
   • **PARK, Min Je**
      **34124 Daejeon (KR)**
   • **KIM, Hak Mook**
      **34124 Daejeon (KR)**
   • **KIM, Do Woan**
      **34124 Daejeon (KR)**

(74) Representative: **Frick, Robert**
   **Lorenz Seidler Gossel**
   **Rechtsanwälte Patentanwälte**
   **Partnerschaft mbB**
   **Widenmayerstraße 23**
   **80538 München (DE)**

(54) **A COOLANT COMPOSITION, AN APPARATUS CONTAINING THE SAME, AND A METHOD OF COOLING AN APPARATUS USING THE SAME**

(57)   The present invention relates to a coolant composition, an apparatus containing the coolant, and a method of cooling the apparatus using the coolant. The coolant composition follows a function C in a range of $3.000 \times 10^{-2}$ to $4.950 \times 10^{-2}$.

EP 4 442 788 A1

**Description**

BACKGROUND OF THE INVENTION

1. Field of the Invention

The present invention relates to a coolant composition, an apparatus containing the same, and a method of cooling the apparatus using the same.

2. Description of the Related Art

A coolant plays a role in absorbing heat generated from a source of heat generation and reducing a temperature of the source of heat generation. Substances with the following characteristics are desirable as a coolant: a high thermal efficiency, a low viscosity, an affordable price, no toxicity, a chemical stability, and anti-corrosion in various equipment.

With the high sophistication of a variety of electronic products such as electric vehicles, more heat is generated in use of the electronic products. Thus, controlling heat generated from electronic products is a necessary consideration to conveniently use products and prevent lifespan reduction of products.

Various conventional arts are present to cool down electronic products. Representative cooling methods are air cooling, water cooling, and oil cooling. It is advantageous that air cooling out of the methods does not require a separate cooling medium to be ready. However, the disadvantage of air cooling is a low cooling efficiency. Water cooling excels at cooling products due to a high thermal conductivity of water. However, the method is difficult to cool products through a direct contact with a source of heat generation.

SUMMARY OF THE INVENTION

The present invention provides a coolant composition, an apparatus containing the same, and a cooling method of cooling the apparatus using the same, the coolant composition being excellent in insulation and cooling.

More specifically, the present invention relates to a coolant composition in which the composition follows function C, and the function C falls in a range of 3.000 x $10^{-2}$ to 4.950 x $10^{-2}$. Herein, the function C being defined as follows:

$$C = 0.170 \times \frac{\rho^{0.428} \times C_p^{0.397} \times k^{0.510}}{\mu^{0.245}}$$

Herein, $\rho$ represents density (g/cm$^3$), $C_p$ for specific heat (J/g°C), k represents heat conductivity (W/mK), and $\mu$ represents kinematic viscosity (cSt).

In one embodiment, the function C range is 3.600 x $10^{-2}$ to 4.920 x $10^{-2}$.

In one embodiment, the coolant composition comprises mineral base oil in an amount of at least 90% by weight, preferably 92% to 98% with respect to the total weight of the coolant composition.

In one embodiment, the mineral base oil has 15 to 35 carbon atoms on average, as measured according to ASTM D2887.

In one embodiment, the mineral base oil has a 5% by weight distillation temperature in a range of 240°C to 410°C, as measured according to ASTM D2887.

In one embodiment, the mineral base oil has a 95% by weight distillation temperature in a range of 330°C to 570°C, as measured according to ASTM D2887.

In one embodiment, the mineral base oil has a paraffin volume of 90% by volume or less, as measured according to ASTM D2786.

In one embodiment, the coolant composition comprises poly-$\alpha$-olefin, ester base oil, or both, as a minor base oil.

In one embodiment, the coolant composition further comprises one or more additives.

In one embodiment, the additives comprise an antioxidant, preferably in an amount of 0.05% to 2% by weight based on the total weight of the coolant composition.

In one embodiment, the additives comprise other additives, preferably selected from one or more of an antifoamer, a corrosion inhibitor, a detergent, a dispersing agent, a friction modifier, an anti-wear agent, an extreme-pressure additive, a viscosity index improver, a pour point depressant, a viscosity modifier, or any mixture thereof, preferably in an amount of 0.05% to 5% by weight based on the total weight of the coolant composition.

In one embodiment, the coolant composition has electro-conductivity from 0 pS/m(picosiemens per meter) or more to 20 pS/m or less, preferably 15 pS/m or less.

The present disclosure further relates to an apparatus comprising a coolant composition according to the invention, which comprises the coolant composition in a cooling circuit.

In one embodiment, the apparatus is an electronic product, preferably selected from an electric vehicle, a battery for an electric vehicle, a data server, or an energy storage device.

Yet further, the present invention relates to a method of cooling an apparatus, the method comprising dissipating heat from a heat source of the apparatus with the help of the coolant composition according to the invention.

The coolant composition of the present invention has excellent properties in insulation and cooling. The use of the coolant composition can provide an effective control over heat generated in equipment operation.

BRIEF DESCRIPTION OF THE DRAWINGS

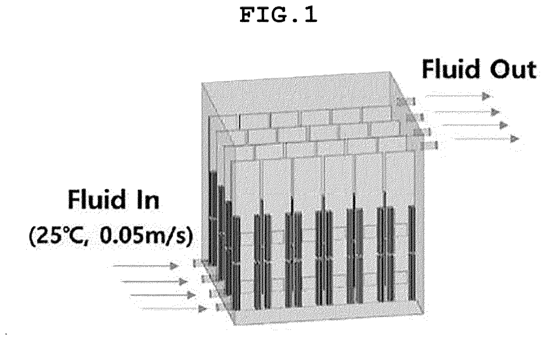

FIG. 1 is a schematic view illustrating cooling performance test according to the embodiments of the present invention.

DESCRIPTION OF THE PREFERRED EMBODIMENTS

The objective, advantages, and characteristics of the present invention are further clarified in the following detailed description and exemplary embodiments with reference to the accompanying figure.

The present invention provides a coolant composition. The composition includes base oil. In one embodiment, the base oil may be mineral oil. In another embodiment, the base oil may include mineral oil as a major base oil and Poly Alpha Olefin (PAO), ester base oil, or both as a minor base oil. In the present disclosure, the major base oil means a base oil whose weight percent with respect to the total base oil weight is more than 50% by weight.

In the present disclosure, the term "mineral oil" refers to oil obtained through crude oil refinery. Generally, PAO exhibits a more excellent performance, but costlier than mineral oil. Although the composition of the present invention uses mineral oil as a major base oil, it is expected that at least equivalent performance and relatively affordable price may be simultaneously achieved compared with the case of PAO use only. Meanwhile, the ester base oil exhibits an excellent heat conductivity but has polarity so that the ester base oil has a less insulation ability compared with mineral oil, and due to the possibility of hydrolysis, the ester base oil is weak at moisture. Therefore, the ester base oil is not suitable for the major base oil of the present invention.

In one embodiment, the weight percent of the base oil may be at least 90% by weight with respect to the total weight of the coolant composition. Particularly, the weight percent of the base oil may be in a range of 90% by weight to 98% by weight such as 91% by weight to 95% by weight, 92% by weight to 97% by weight, 93% by weight to 96% by weight, or 94% by weight to 97.5% by weight. The weight percent of the base oil may be more particularly in a range of 92% by weight to 98% by weight and even more particularly in a range of 93% by weight to 98% by weight. In the case of less than the weight percent of the base oil, the amount of the used additives costlier than the base oil increases so that the price of the coolant composition, a final product, goes up, which is undesirable.

The mineral base oil may fulfill at least one following characteristic, more particularly at least two characteristics, and the most particularly all the following characteristics:

- In terms of the average carbon number measured based on ASTM D2887, the mineral base oil may have 15 to 35 carbon atoms on average.
- In terms of a 5% by weight distillation temperature measured based on ASTM D2887, the mineral base oil may have a 5% by weight distillation temperature in a range of 240°C to 410°C.
- In terms of a 95% by weight distillation temperature measured based on ASTM D2887, the mineral base oil may have a 95% by weight distillation temperature in a range of 330°C to 570°C.
- In terms of the paraffin volume measured based on ASTM D2786, the mineral base oil may have paraffin volume of 90% by volume or less.

In the case where at least one parameter range is below the numerical range described above (average carbon number, 5% by weight distillation temperature, and 95% by weight distillation temperature of the mineral base oil included in the coolant composition), the amount of volatile oil fraction in the composition increases so that poor stability may occur. Conversely, in the case where at least one parameter range is above the numerical range described above, kinematic viscosity of the coolant composition increases, which leads to a poor flow so that cooling efficiency may decrease.

The coolant composition may further include an additive. The additive includes an antioxidant, other additives, or both. Herein, the other additives refer to additives capable of being added to the composition other than an antioxidant. Examples of the other additives comprise an antifoamer, a corrosion inhibitor, a detergent, a dispersing agent, a friction modifier, an anti-wear agent, an extreme-pressure additive, a viscosity index improver, a pour point depressant, and a viscosity modifier, or any combination thereof.

In one embodiment, the weight percent of the antioxidant with respect to the total weight of the coolant composition may be 3.0% by weight or less such as more than 0% by weight to 3.0% by weight or less, 0.01% by weight to 2.5% by weight, 0.05% by weight to 2.0% by weight, 0.1% by weight to 1.0% by weight, or 0.5% by weight to 1.5% by weight. Particularly, the weight percent of the antioxidant may be 2.0% by weight or less such as more than 0% by weight to 2.0% by weight or less. More particularly, the weight percent of the antioxidant may be in a range of 0.05% by weight or more to 2% by weight or less.

In addition, the weight percent of the other additives with respect to the total weight of the coolant composition may be in a range of more than 0% by weight to 8% by weight such as 0.01% by weight to 7% by weight, 0.05% by weight to 6% by weight, 0.1% by weight to 5% by weight, 0.2% by weight to 3% by weight, 0.5% by weight to 2% by weight, or 1% by weight to 4% by weight. Particularly, the weight percent of the other additives may be in a range of more than 0% by weight to 5% by weight, more particularly may be in a range of 0.05% by weight to 5% by weight.

The coolant composition of the present invention is characterized by following function C in a predetermined range, the function C being defined as follows:

$$C = 0.170 \times \frac{\rho^{0.428} \times C_p^{0.397} \times k^{0.510}}{\mu^{0.245}}$$

Herein, $\rho$ represents density (g/cm$^3$), $C_p$ for specific heat (J/g·°C), k represents heat conductivity (W/mK), and $\mu$ represents kinematic viscosity (cSt). Individual parameters (density, specific heat, heat conductivity, and kinematic viscosity) which the function C is composed of are a temperature-dependent parameter. To feature the values of the function C, the parameters are measured at an identical specific temperature.

In one embodiment, the coolant composition follows the function C in a range of $3.000 \times 10^{-2}$ to $4.950 \times 10^{-2}$ when measured at a temperature of 40C. The specific numerical range is required to be understood as including an arbitrary subrange between the lower and upper bounds. The function C range of $3.000 \times 10^{-2}$ to $4.950 \times 10^{-2}$ includes subranges such as $3.000 \times 10^{-2}$ to $3.200 \times 10^{-2}$, $3.200 \times 10^{-2}$ to $3.700 \times 10^{-2}$, $3.600 \times 10^{-2}$ to $4.200 \times 10^{-2}$, $4.100 \times 10^{-2}$ to $4.600 \times 10^{-2}$, and $4.500 \times 10^{-2}$ to $4.950 \times 10^{-2}$. Particularly, the function C range may be $3.200 \times 10^{-2}$ to $4.930 \times 10^{-2}$. More particularly, the function C range may be $3.250 \times 10^{-2}$ to $4.920 \times 10^{-2}$. Even more particularly, the function C range may be $3.600 \times 10^{-2}$ to $4.920 \times 10^{-2}$.

In the case of outside the described function C range followed by the composition, a limitation that the composition is difficult to be used as a coolant composition may occur. To be specific, when the value of the function C followed by the composition is less than $3.000 \times 10^{-2}$, the efficiency of a pump for moving the composition may decrease, and the cooling performance of the composition itself may decline, or both. Conversely, when the value of the function C followed by the composition is more than $4.950 \times 10^{-2}$, the amount of vaporized composition may increase, and the flash point of the composition may be reduced so that there is a higher risk of fire.

In one embodiment, the coolant composition may have electro-conductivity from 0 pS/m or more to 20 pS/m or less as measured by IEC 60247. Particularly, the coolant composition may have electro-conductivity of 19 pS/m or less, more particularly, electro-conductivity of 18 pS/m or less, and even more particularly, electro-conductivity of 16 pS/m or less, and even more particularly, electro-conductivity of less than 15 pS/m.

In the case of the composition having electro-conductivity of more than 20 pS/m, electricity flows through the composition, and thus there is a risk of short-circuit within electrical equipment so that the equipment may be damaged.

The coolant composition of the present invention fulfills at least one of the conditions such as in the predetermined function C described above or electro-conductivity, and particularly both. Thus, excellent performances in insulation and cooling are all possible to be achieved.

The present invention further provides an apparatus (equipment) containing the coolant composition according to the invention. In addition, the present invention provides a method of cooling an apparatus by using the coolant composition of the invention.

Particularly, the apparatus may be an electronic product. Examples comprise electric vehicles, specifically batteries for electric vehicles, data server, or energy storage devices.

The apparatus may comprise the coolant and may be cooled by dissipating heat from a heat source through the coolant. The coolant may be circulated in a coolant circuit of the apparatus. The heat source may be brought in direct contact with the coolant composition of the present invention. Due to high electro-conductivity of water, a refrigerant of water cooling, water cooling is difficult to make the direct contact, a method of cooling the apparatus through a direct contact. In addition, air cooling uses air as a medium of heat exchange, which means it is possible to make a direct cooling, but cooling efficiency decreases due to a low specific heat of air. The coolant composition of the present invention makes it possible to directly cool sources of heat generation, which ultimately makes it possible to achieve an excellent cooling efficiency compared with the conventional cooling methods.

Hereinafter, preferred examples are proposed for better understanding of the present invention.

Examples

1. Preparing coolant composition

Coolant compositions including a 97.5% by weight base oil, a 0.5% by weight antioxidant, and 2% by weight other additives are prepared in Preparation Examples 1 to 5, and Comparative Preparation Example 1. Properties of base oil included in the individual coolant compositions are as follows in Table 1.

[Table 1]

|  | Preparation Example 1 | Preparation Example 2 | Preparation Example 3 | Preparation Example 4 | Preparation Example 5 | Comparativ e Preparation Example 1 |
|---|---|---|---|---|---|---|
| Average number of carbon atoms | 31-35 | 26-30 | 19-23 | 17-21 | 15-19 | 43-47 |
| 5 wt% distiliation temperature (°C) | 390-410 | 370-390 | 280-300 | 280-300 | 245-265 | 445-465 |
| 95 wt% distillation temperature (°C) | 520-540 | 455-475 | 410-430 | 395-415 | 340-360 | 615-635 |
| Paraffin volume percent (vol%) | 55-65 | 60-70 | 45-55 | 70-80 | 45-55 | 80-90 |

Physical characteristics of the individual coolant compositions (At temperature 40°C) are as follows in Table 2.

[Table 2]

|  | Measuring method | Preparatio n Example 1 | Preparatio n Example 2 | Preparatio n Example 3 | Preparatio n Example 4 | Preparatio n Example 5 | Comparativ e Preparation Example 1 |
|---|---|---|---|---|---|---|---|
| Density (g/cm$^3$) | ASTM D4052 | 0.8259 | 0.8206 | 0.819 | 0.79965 | 0.7953 | 0.8198 |
| Heat conductivity (W/mK) | ASTM D7896 | 0.1448 | 0.1388 | 0.1283 | 0.1317 | 0.1256 | 0.1555 |
| Specific heat (J/g°C) | ASTM D7896 | 2.0839 | 2.0241 | 1.8962 | 1.9875 | 1.9172 | 2.2277 |
| Kinematic viscosity (cSt) | ASTM D445 | 35.16 | 19.60 | 8.772 | 6.517 | 4.050 | 61.80 |
| Flash point (°C) | ASTM D92 | 244 | 224 | 170 | 165 | 130 | 271 |

(continued)

| | Measuring method | Preparation Example 1 | Preparation Example 2 | Preparation Example 3 | Preparation Example 4 | Preparation Example 5 | Comparative Preparation Example 1 |
|---|---|---|---|---|---|---|---|
| Electro-conductivity (pS/m) | | < 15 | < 15 | < 15 | < 15 | < 15 | < 15 |
| Function C | | 0.03271 | 0.03641 | 0.04147 | 0.04559 | 0.04917 | 0.02982 |

2. Cooling performance test

Cooling of the server of a data center was simulated by using the coolant compositions, as shown in Preparation Examples 1 to 5, and Comparative Preparation Example 1. The schematic view of the simulation is described in FIG. 1, and the configurations of the server of the data center are as follows in Table 3.

[Table 3]

| | Board | CPU | Memory | Bathtub |
|---|---|---|---|---|
| Number | 24 | 48 | 384 | - |
| Thickness, mm | 10 | 4 | 2 | 600 |
| Width, mm | 90 | 40 | 30 | 600 |
| Height, mm | 500 | 40 | 150 | 600 |
| Amount of heat generation, W/ea | - | 12.5 | 1.56 | - |

Inflow and outflow of the coolant compositions into the bathtub took place, and cooling was executed in a method of immersion cooling meaning that the data server circuits in the bathtub are immersed in the coolant. The inflow of the coolant compositions took place at a temperature of 25°C, and at a speed of 0.05 m/s.

The simulation results by using the individual compositions were as follows in Table 4.

[Table 4]

| | Preparation Example 1 | Preparation Example 2 | Preparation Example 3 | Preparation Example 4 | Preparation Example 5 | Comparative Preparation Example 1 |
|---|---|---|---|---|---|---|
| CPU Average temperature (°C) | 55.5 | 52.4 | 49.1 | 46.9 | 45.3 | 58.5 |

As a result of the simulation, the average temperature of CPU cooled by the coolant compositions, as shown in Preparation Examples 1 to 5, was maintained in a range of 45°C to 56°C, and other limitations such as electrical current passing or short-circuit were not observed despite the execution of immersion cooling. Thus, the coolant composition of the present invention is expected to be used as a new coolant to cool electronic products in which a high heat is generated. Meanwhile, in the case of Comparative Preparation Example 1 being outside the numerical function C range of the present invention, a poorer cooling performance was able to be identified compared with Preparation Examples 1 to 5. 1 to 2°C or more difference in temperature in the simulation under the same conditions is very significant, and the difference may be considered to be more outstanding in the application to large-scale electronic devices generating a lot more heat.

**Claims**

1. A coolant composition following a function C in a range of $3.000 \times 10^{-2}$ to $4.950 \times 10^{-2}$, the function C being defined as follows:

$$C = 0.170 \times \frac{\rho^{0.428} \times C_p^{0.397} \times k^{0.510}}{\mu^{0.245}}$$

   wherein, $\rho$ represents density (g/cm$^3$), $C_p$ represents specific heat (J/g·°C), k represents heat conductivity (W/mK), and $\mu$ represents kinematic viscosity (cSt).

2. The coolant composition of claim 1, wherein the function C range is $3.600 \times 10^{-2}$ to $4.920 \times 10^{-2}$.

3. The coolant composition of any preceding claim, wherein the coolant composition comprises mineral base oil in an amount of at least 90% by weight, preferably 92% to 98% with respect to the total weight of the coolant composition.

4. The coolant composition of claim 3, wherein the mineral base oil comprises 15 to 35 carbon atoms on average, as measured according to ASTM D2887.

5. The coolant composition of claim 3 or 4, wherein the mineral base oil has a 5% by weight distillation temperature in a range of 240°C to 410°C, as measured according to ASTM D2887.

6. The coolant composition of any one of claims 3 to 5, wherein the mineral base oil has a 95% by weight distillation temperature in a range of 330°C to 570°C, as measured according to ASTM D2887.

7. The coolant composition of any one of claims 3 to 6, wherein the mineral base oil has a paraffin volume of 90% by volume or less, as measured according to ASTM D2786.

8. The coolant composition of any preceding claim, wherein the coolant composition comprises poly-$\alpha$-olefin, ester base oil, or both, as a minor base oil.

9. The coolant composition of any preceding claim, wherein the coolant composition further comprises one or more additives.

10. The coolant composition of claim 4, wherein the additives comprises an antioxidant, preferably in an amount of 0.05% to 2% by weight based on the total weight of the coolant composition.

11. The coolant composition of claim 9 or 10, wherein the additives comprise other additives, preferably selected from one or more of an antifoamer, a corrosion inhibitor, a detergent, a dispersing agent, a friction modifier, an anti-wear agent, an extreme-pressure additive, a viscosity index improver, a pour point depressant, a viscosity modifier, or any combination thereof, preferably in an amount of 0.05% to 5% by weight based on the total weight of the coolant composition.

12. The coolant composition of any preceding claim, wherein the coolant composition has an electro-conductivity from 0 pS/m or more to 20 pS/m or less, preferably 15 pS/m or less.

13. An apparatus comprising a heat source and a coolant composition of any preceding claim, preferably in a coolant circuit that brings the coolant composition into direct contact with the heat source.

14. The apparatus of claim 13, wherein the apparatus is an electronic product, preferably selected from an electric vehicle, a battery for an electric vehicle, a data server, or an energy storage device.

15. A method of cooling an apparatus, preferably an apparatus of claim 13 or 14, the method comprising dissipating heat from the heat source of the apparatus by the coolant composition of any one of claims 1 to 12, preferably by circulating the coolant composition in a coolant circuit that brings the coolant composition into direct contact with the heat source.

FIG.1

Fluid Out

Fluid In
(25℃, 0.05m/s)

Europäisches
Patentamt

European
Patent Office

Office européen
des brevets

# EUROPEAN SEARCH REPORT

**Application Number**

EP 24 15 3350

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/045050 A1 (IDEMITSU KOSAN CO [JP]) 3 March 2022 (2022-03-03) * paragraphs [0009] - [0010], [0055] - [0071], [0075]; claims * | 1-15 | INV. C09K5/10 H01M10/6567 |
| X | WO 2020/257368 A1 (EXXONMOBIL RES & ENG CO [US]) 24 December 2020 (2020-12-24) * paragraphs [0001], [0027] - [0029], [0032], [0055] - [0062], [0077], [0102] - [0106], [0275]; figure 1; table 3 * | 1-15 | |
| X | US 2022/259476 A1 (SHORT AMY L [US] ET AL) 18 August 2022 (2022-08-18) * paragraphs [0006] - [0010], [0014], [0053]; claims; tables 1,2 * | 1-15 | |
| X | WO 2022/076207 A1 (EXXONMOBIL CHEMICAL PATENTS INC [US]) 14 April 2022 (2022-04-14) * paragraphs [0002], [0009], [0016] - [0023]; claims; figures; tables 4,6 * | 1-15 | TECHNICAL FIELDS SEARCHED (IPC) |
| X | WO 2022/038313 A1 (NESTE OYJ [FI]) 24 February 2022 (2022-02-24) * page 1, line 1 - page 2, line 22 * * page 7, lines 8-31 * * page 17, lines 5-12; claims; examples; tables 4,4.1,13 * | 1-15 | C09K H01M |

The present search report has been drawn up for all claims

| Place of search | Date of completion of the search | Examiner |
|---|---|---|
| The Hague | 14 June 2024 | Martinez Marcos, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 3350

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2024

| Patent document cited in search report | Publication date | Patent family member(s) | | Publication date |
|---|---|---|---|---|
| WO 2022045050 A1 | 03-03-2022 | CN | 115698235 A | 03-02-2023 |
| | | EP | 4206307 A1 | 05-07-2023 |
| | | JP | 7373474 B2 | 02-11-2023 |
| | | JP | 2022037689 A | 09-03-2022 |
| | | US | 2023272297 A1 | 31-08-2023 |
| | | WO | 2022045050 A1 | 03-03-2022 |
| WO 2020257368 A1 | 24-12-2020 | US | 10712105 B1 | 14-07-2020 |
| | | US | 11092393 B1 | 17-08-2021 |
| | | WO | 2020257368 A1 | 24-12-2020 |
| US 2022259476 A1 | 18-08-2022 | BR | 112021025138 A2 | 15-02-2022 |
| | | CA | 3143152 A1 | 17-12-2020 |
| | | CN | 114128013 A | 01-03-2022 |
| | | DK | 3984092 T3 | 24-04-2023 |
| | | EP | 3984092 A1 | 20-04-2022 |
| | | EP | 4231413 A2 | 23-08-2023 |
| | | ES | 2943957 T3 | 16-06-2023 |
| | | FI | 3984092 T3 | 26-04-2023 |
| | | JP | 2022537933 A | 31-08-2022 |
| | | KR | 20220019026 A | 15-02-2022 |
| | | PL | 3984092 T3 | 22-05-2023 |
| | | US | 2022259476 A1 | 18-08-2022 |
| | | WO | 2020252235 A1 | 17-12-2020 |
| WO 2022076207 A1 | 14-04-2022 | CN | 116457984 A | 18-07-2023 |
| | | EP | 4225870 A1 | 16-08-2023 |
| | | US | 2023365850 A1 | 16-11-2023 |
| | | WO | 2022076207 A1 | 14-04-2022 |
| WO 2022038313 A1 | 24-02-2022 | AU | 2021327741 A1 | 02-03-2023 |
| | | CA | 3187196 A1 | 24-02-2022 |
| | | CN | 115956110 A | 11-04-2023 |
| | | EP | 4200378 A1 | 28-06-2023 |
| | | FI | 20205816 A1 | 22-02-2022 |
| | | JP | 2023538628 A | 08-09-2023 |
| | | KR | 20230054371 A | 24-04-2023 |
| | | US | 2023313015 A1 | 05-10-2023 |
| | | WO | 2022038313 A1 | 24-02-2022 |

EPO FORM P0459

For more details about this annex : see Official Journal of the European Patent Office, No. 12/82